# EUROPEAN PATENT SPECIFICATION

(11) **EP 2 994 768 B1**
(45) Date of publication and mention of the grant of the patent: **19.10.2016**
(21) Application number: 14720138.8
(22) Date of filing: 29.04.2014
(51) Int. Cl.: G01R 33/00

(54) **DEVICE FOR MEASURING AND CLOSED-LOOP CONTROL OF A MAGNETIC FIELD GENERATED BY AN ELECTROMAGNET**
VORRICHTUNG ZUR MESSUNG UND REGELUNG EINES VON EINEM ELEKTROMAGNETEN ERZEUGTEN MAGNETFELDES
DISPOSITIF DE MESURE ET DE COMMANDE EN BOUCLE FERMÉE D'UN CHAMP MAGNÉTIQUE GÉNÉRÉ PAR UN ÉLECTRO-AIMANT

(30) Priority: 08.05.2013 DE 102013104778
(43) Date of publication of application: 16.03.2016
(73) Proprietor: Heidelberg Ionenstrahl-Therapie (HIT) Betriebs-Gesellschaft Am Universitätsklinikum Heidelberg MBH, 69120 Heidelberg (DE)
(72) Inventor: FELDMEIER, Eike, 64380 Roßdorf (DE)
(74) Representative: Reiser & Partner
(86) International application number: PCT/EP2014/058659
(87) International publication number: WO 2014/180703

(56) References cited:
- DE-B3-102005 045 537
- US-A1- 2011 116 200
- E Feldmeier ET AL: "THE FIRST MAGNETIC FIELD CONTROL (B-TRAIN) TO OPTIMIZE THE DUTY CYCLE OF A SYNCHROTRON IN CLINICAL OPERATION", , 1 January 2012 (2012-01-01), XP055129453, Retrieved from the Internet: URL:http://accelconf.web.cern.ch/accelconf /ipac2012/papers/thppd002.pdf [retrieved on 2014-07-16]
- E Feldmeier ET AL: "MAGNETIC FIELD CORRECTION IN NORMAL CONDUCTING SYNCHROTRONS", , 1 May 2010 (2010-05-01), XP055129449, Retrieved from the Internet: URL:https://accelconf.web.cern.ch/accelcon f/IPAC10/papers/mopd004.pdf [retrieved on 2014-07-16]

## Description

The invention concerns a device and a method for measuring and closed-loop control of a magnetic field generated by an electromagnet.

Electromagnets are deployed in many technology sectors, in particular to generate strong magnetic fields that also alter with time. A device that has a large number of electromagnets is a particle accelerator. Charged particles, for example electrons, protons, or ions can be accelerated to a high velocity by means of an electromagnetic field. Particle accelerators have been used for some time now in both basic research and for therapeutic purposes. In ion therapy, various ions, for example protons, carbon ions, helium ions or oxygen ions are brought up to a prescribed energy level in a particle accelerator and are then directed into the tissue that is to be treated. On entry into the body, the ion loses energy, wherein a large part of the energy is released in a narrow field. Here it is advantageous that the ion passes through sound tissue and does not damage it; rather the therapeutically effective energy release takes place only in the tissue that is to be treated.

The particle accelerator for heavy ion therapy comprises an ion source for purposes of generating charged particles of the desired type of ion. A linear accelerator adjoins the ion source; this accelerates the particle beam up to a first energy level. In addition the ions are bunched and any remaining accompanying electrons are separated out. The ions that have been accelerated up to the first energy level are then supplied to a ring accelerator, which accelerates the beam further and brings it up to a second energy level, the extraction level. In order that the ions can be held on the circular track of the ring accelerator, a ring accelerator comprises a plurality of electromagnets, which can be designed as dipoles, quadrupoles, or even sextupoles. The electromagnets build a magnetic field, which constrains the beam onto a closed circular track. In addition to the electromagnets that maintain the circular track, the ring accelerator features an accelerator section; when the ions pass through the latter, they are accelerated. In the extraction process, the accelerated ions are led out of the ring accelerator and are supplied via a beam guide to the therapy rooms.

If the ring accelerator is designed as a synchrotron, the magnetic field is controlled synchronously with the increasing rotational frequency of the particles. Here, the energy of the ions, which rotate on the circular track at a fixed frequency, is determined by, amongst other factors, the integral magnetic field that acts on the ions.

With the electromagnets arranged in the ring accelerator, the magnetic field can be variably adjusted by means of the current delivered to the coil. Here, electromagnets in the form of dipoles, quadrupoles and sextupoles can be used so as to steer and focus the particle beam. The electromagnets are provided with a gap, through which the ion beam is directed.

Dipoles usually have a rectangular cross-section with a gap in the interior and possess two poles; these are arranged opposite one another and are directed into the interior of the dipole. A coil is arranged on two opposite sides of the dipole. In the region between the poles, the so-called magnet gap, a homogeneous magnetic field arises as a result of an electric current in the coils. In the ideal case, the magnetic flux density in the region between the poles is constant, and the edge fields, where the magnetic flux density alters in direction and magnitude, have only a small effect on the beam. Dipoles are used in the ring accelerator so as to deflect the particle beam. Here, the particle beam describes a track on a circular sector.

Quadrupoles have a pole at each corner and a coil is located on each side. Quadrupoles focus and defocus the beam. A quadrupole that focuses the beam in one plane, defocuses it in the other plane. Quadrupoles are therefore mainly used in pairs. The magnetic field in the centre of a quadrupole is zero and increases linearly from the centre.

Sextupoles are six-cornered or round and have six poles and six coils. The poles are usually arranged in the corner regions and the coils are arranged on the sections connecting the corners. Sextupoles are used in a ring accelerator so as to correct the chromaticity of the beam. The magnetic field of a sextupole alters with the square of the distance from the centre.

The electromagnets usually have a core of ferromagnetic iron, so that by virtue of the high permeability of the iron, the magnetic flux is mainly directed through the iron. The magnetic field strength in the air gap of the magnet (magnet gap) arises as a result of the spatial interruption of the iron. The magnetic flux continues through the air and generates a magnetic field between the poles. Since the field lines emerge at right angles from the surface of the pole, the shape of the field can thus be determined by the shape of the poles.

The ferromagnetic iron possesses hysteresis, so that the magnetic field generated by the magnet not only depends on the field currently induced externally by the coil through which the current flows, but also depends on the hysteresis of the magnetisation. If the current flowing through the coil is stopped, a residual magnetic field, the so-called remanence field, still remains. As a result of this remanence field the magnetic flux density of the electromagnet alters with time while the electric current remains constant. The varying remanence field makes the closed-loop control of an electromagnet more difficult; in particular it is not possible to use the electric current that is given to the electromagnets exclusively as a reference variable for closed-loop control.

The field errors brought about by hysteresis can be compensated for in that at the end of a cycle the magnetic field strength generated in the electromagnet lies above the field strength that is necessary for the acceleration of the ions. By this means, the magnet always travels through the same hysteresis loop and creates known preconditions for the following cycle, since the remanence field of the magnet is the same at the start of each cycle. Here it is, however, disadvantageous that time is required for this procedure, which cannot be used for the extraction of ions.

Eddy currents are a further influencing variable that occur in an electromagnet. Eddy currents are electric currents that are induced in a conducting material as a result of a magnetic field that alters with time. Eddy currents occur in all conducting materials and are thus also present in the iron core of the electromagnet. Eddy currents can, for example, be reduced by the construction of the iron core from laminated sheets, but always occur in particular in the presence of strongly varying magnetic fields, and influence the magnetic field itself. Thus, the unavoidable occurrence of eddy currents also makes the closed-loop control of an electromagnet more difficult.

Field errors arise as a result of the two effects described above, hysteresis and eddy current; these errors affect the quality of the ion beam. In particular in the case of compact ring accelerators the field error translates directly into a measurable deviation in the position of the rotating beam.

For the maximum possible therapeutic success with minimum possible impact on the surrounding tissue it is, however, necessary that the ion beam attains to the desired tissue very accurately and releases its energy there. For example, carbon ions are brought up to an energy level of approximately 430 MeV/u (MeV per nucleon) and are to release their energy in the target tissue with an accuracy of less than 1 mm. From this requirement it follows that the field error of, in particular, the beam deflecting dipoles, must be less than 1.45 x 10⁻⁴ with respect to the maximum value of magnetic field strength of 1.5 T. This approximately corresponds to 4.5 times the earth's magnetic field in Central Europe of 48 µT. It follows from this that electromagnets must be very accurate on the one hand and by virtue of the very small rotation period of the ions, must also be controlled very rapidly on the other hand.

Various methods for the measuring of magnetic fields are known. Hall probes can measure magnetic fields with both constant and varying magnetic flux. With time-consuming calibrations, it is also possible to achieve an accuracy that is better than the above-described accuracy with Hall probe measurements. Moreover, with Hall probe measurements the absolute magnetic field is measured and the result is immediately available. However, a Hall probe only measures the local magnetic field at one point.

In an alternative method, the magnetic field is measured with an induction coil. In an induction coil, Faraday's law of induction is translated into practice. If the magnetic flux through a conducting coil alters, a current is induced in the coil and a voltage is generated at the open ends. The latter is proportional to the alteration of the magnetic flux. Such an induction coil is also designated as a pickup coil; these can measure alterations in magnetic fields of less than 10⁻¹⁰ T. However, the problem with this method is that it is only the alteration of the field that is measured, and not the absolute magnetic field. It is therefore necessary to integrate the voltage signal of the induction coil in order to obtain the magnetic field. It is true that with the integrators that are available today the required accuracy can be achieved; however, it is not possible to execute measurements in real time with these integrators, since the data can be processed only after the measurements have been taken.

Thus, with the means that are currently available, it is necessary to calibrate the measuring device and to load the electromagnets once in each cycle to their maximum in order to generate a comparable remanence field. As a result, the time required for the acceleration and extraction of ions is unnecessarily long.

In EP 2 274 634 B1, a device is proposed for the measuring and closed-loop control for a magnetic field generated by an electromagnet; this has measuring devices that are integrated into the electromagnet and directly measure the magnetic field prevailing in the magnetic gap of the electromagnet. Furthermore, it is proposed to provide a first measuring device that is designed as a pickup coil, and which integrally measures the varying magnetic field. A second measuring device, designed as a Hall probe, measures the absolute magnetic field at a local position. An integrator unit is assigned to the first measuring device. This is necessary since the first measuring device can only measure alterations of the magnetic field and the magnetic field that is present can only be determined via a time-variant integration. In this configuration, it is advantageous that the magnetic field acting on the particle beam to be deflected can be measured directly and very accurately. By the direct measurement of the magnetic field the influences of the above described remanence and eddy currents can be measured. The measured value can be used to adapt the electric current required for the excitation of the electromagnets to the measured magnetic field, and thus to control the electromagnet dynamically.

A basic principle of such a device for measuring and closed-loop control of a magnetic field was described in: E. Feldmeier et al; "The first magnetic field control (B-TRAIN) to optimize the duty cycle of a synchroton in clinical operation" (abstract); 1 January 2012, ISBN 978-3-95450-115-1; page 3503 and E. Feldmeier et al; "Magnetic field correction in normal conducting synchrotons" (abstract); 1 May 2010; ISBN 978-92-9083-352-9; page 675.

DE 10 2005 045 537 B3 shows a device for determining a magnetic field strength of an electromagnet.

In principle, however, it is problematical that the accuracy of the measured field strength depends on error sources, which, in particular, are based on errors altering with time, for example temperatures altering as a result of signal noise, frequency fluctuations, and similar. For this reason, it is necessary to calibrate the device at regular intervals. By virtue of the high requirements placed on the accuracy of the beam and thus on the accuracy of the device to measure the magnetic field, it is necessary to execute a calibration at intervals of a few seconds. During the calibration, however, it is not possible to extract an ion beam from the accelerator.

It is object of the invention to provide a device for the measuring and closed-loop control for a magnetic field generated by an electromagnet having a reduced time required for the calibration and preparation of the electromagnet.

This object is achieved with the features of Claims 1 and 12. The subclaims refer to advantageous embodiments.

The inventive device for the measuring and closed-loop control of a magnetic field generated by an electromagnet comprises a first measuring device for purposes of measuring the absolute magnetic field strength of the magnetic field, a second measuring device for purposes of measuring the alteration of the magnetic field strength of the magnetic field, at least two integrators for purposes of determining the magnetic field strength of the alteration of the magnetic field strength measured in the second measuring device, which integrators are arranged in parallel to one another, calibration means, a unit for purposes of comparing the magnetic field strength measured by the first measuring device and the second measuring device, and a further unit for purposes of comparing the measured magnetic field strength with a prescribed design field strength.

It is one advantage of the device according to the invention that by means of the at least two integrators a plurality of integrator paths ensue that are arranged in parallel to one another. The integrators are arranged in parallel interconnection. This makes it possible to switch one integrator into the operating circuit and converting the voltage provided by the second measuring device into countable pulses, from which in turn the current integral field strength can be determined, and that a second integrator is not active, but rather can run through a calibration cycle. Thus, errors, for example as a result of temperature variation, noise and similar, can be compensated, so that a high accuracy for the output signal can be ensured. A further advantage is the fact that the calibration can take place at the same time as the actual measurements. For calibration purposes, the respective integrator and the calibration means are connected. The magnetic field of the electromagnet can be measured in real time, which in turn enables real-time closed-loop control of the electromagnets. Since calibration is executed in parallel to the measurements, the measurement process does not need to be interrupted for the calibration. A further advantage is the fact that the hysteresis characteristic of the electromagnet, that is to say its remanence field, is of minor importance, since the measuring of the real magnetic field takes place in real time. As a result, the maximum loading of electromagnet for purposes of achieving a remanence field that is always the same can be dispensed with.

By using a pickup coil, the integral magnetic field can be measured in the region, through which the particle beam travels, and which is responsible for the deflection and focusing of the particle beam. However, since the second measuring device can only detect alterations of the magnetic field, a first measuring device is also provided that can measure the absolute magnetic field. Here, the magnetic field measured by the first measuring device is preferably measured under predictable conditions, and forms the starting value for the alteration of the magnetic field measured by the second measuring device.

The integrators are arranged such that one integrator integrates the values measured by the second measuring device, while the other integrator runs through a calibration cycle. Due to this inventive configuration, the high-accuracy integrator can deliver in real time the integral of the analog voltage located at input to the integrator, which arises in the pickup coil. At the same time, a calibration of the other integrator can take place continuously, which moreover can be executed under operational conditions. For this purpose, two identical integration paths are used, which automatically switch over after calibration. The ongoing measurements are not impaired thereby. At prescribed time intervals, for example every 4 seconds, a new calibration can be executed.

The first measuring device can be designed as a Hall probe. In Hall probes, the so-called Hall effect is used for purposes of measuring the magnetic field. In a conductor, through which current is flowing, the electrons are deflected at right angles to an externally applied magnetic field by virtue of the Lorentz force. In the third spatial direction, in other words at right angles to the current and at right angles to the flow of electrons, an excess of electrons arises at one side of a conductor and thereby a voltage. The so-called Hall voltage is a function of the charge carrier mobility in the conductor. Thus, Hall probes can measure the absolute magnetic flux, but just locally at one point.

The second measuring device can be designed as a pickup coil. A pickup coil is an induction coil in which Faraday's law of induction is translated into practice. If the magnetic flux through a conducting coil alters, an e-field is generated, which induces a current in the pickup coil and generates a voltage at the open ends. The latter is proportional to the alteration of the magnetic flux. Often a ferromagnetic material is introduced into the pickup coil in order to concentrate the magnetic flux in the coil. The sensitivity of the pickup coil is a function of the permeability of the core material, the surface area of the pickup coil, the number of windings, and the alteration of the magnetic flux through the pickup coil. The bandwidth of the pickup coil is limited by the ratio of the inductance to the resistance of the pickup coil; this determines the damping time with which an induced current reduces if the external field is removed. Alterations in the magnetic field of less than 10⁻¹⁰ T can be measured with induction coils. There is no upper limit. They are typically operated in a frequency range from 1 Hz to 1 MHz. The size of the induction coil varies greatly, depending upon the application, in a range from a few mm2 up to several m2.

Other conceivable measuring devices for measuring magnetic fields are magnetoresistive magnetometers, proton magnetometers, flux gate sensors, SQUIDS, or optically pumped magnetometers. Magnetoresistive magnetometers are based on the magnetoresistive effect, an alteration of resistance as a result of an external magnetic field. Proton magnetometers utilise the reaction of the protons in hydrocarbon molecules to a magnetic field. Flux gate sensors consist of a ferromagnetic material, on which two coils are wrapped. They utilise the magnetic induction together with the hysteresis that occurs with all ferromagnetic materials. The SQUID (superconducting quantum interference device) utilises two macroscopic quantum phenomena that occur with superconductivity. This is the most sensitive method for measurement of alterations of the magnetic flux. Optically pumped magnetometers utilise the Zeemann effect. The electrons of an atom interact via their magnetic moments, which originate from the spin, and also via their electrical current densities, which arise as a result of the orbital angular momentum, with external magnetic fields.

The pickup coil can be fitted along the beam guide of the electromagnet and can integrally measure the alteration of the magnetic field in the magnet gap. Here, the pickup coil surrounds the whole of the magnetic flux that acts on the particle beam, including the edge fields at the start and end of the dipole. The action of the magnetic field on the particle beam and on the induction coil is thus comparable. In this configuration, the pickup coil completely measures the magnetic field that the particle beam "senses".

The integrators can feature a voltage-to-frequency converter. A voltage-to-frequency converter is a unit that converts an electrical voltage into a frequency that is proportional to it. The second measuring device delivers an electrical voltage as a measurement signal, which forms the input signal to the voltage-to-frequency converter. An electrical current flows in the voltage-to-frequency converter that is proportional to the voltage; this current charges a capacitor. Upon arrival at a threshold value for the charge a negative-feedback capacitor is charged by means of a short current pulse that is fixed in duration and magnitude in the counter-direction. The higher the input current, the more often is the counter-charging process necessary. The frequency of these current pulses is proportional to the input voltage. Here, it is advantageous if the frequency determined from the analog voltage can be processed further digitally by simple means.

The integrators can feature a comparator, a sample-and-hold element, a negative-feedback capacitor and a flip-flop cycled via a clock, which discharges the negative-feedback capacitor after a described time has elapsed. Negative-feedback capacitors have a finite discharge time period, so that the negative-feedback capacitor can only discharge in the presence of sufficiently low excitation frequencies. For higher frequencies compensation circuits are required. An advantageous compensation circuit takes the form of a circuit in which the negative-feedback capacitor is discharged after a described time has elapsed by means of a sample-and-hold element and a flip-flop cycled via a clock.

The integrators can be assigned to a time-controlled switching unit, which initiates the changeover of the operating states of the integrators. Such a switching unit can be a multiplexer. A multiplexer (MUX) is a selection circuit in the analog and digital electronics, with which a path can be selected from a number of input signals and a number of output signals.

The second measuring device can record a voltage induced as a consequence of an alteration of the magnetic field, which voltage forms the input value to the integrator. If the second measuring device is designed as a pickup coil, an electrical voltage is induced in the coil if the magnetic field alters. Here, the voltage is a function of the alteration of the magnetic field strength and the number of coil windings. The pickup coil is preferably designed such that with a maximum alteration of the field strength of 1.5 T/s an electrical voltage of between ±10 V, preferably between ±5 V, is induced. The induced voltage measured by the second measuring device can be provided with an offset voltage, so that the measured induced voltage plus the offset voltage forms the input signal to the integrator. By this means negative voltages in the case of a decreasing magnetic field can also be mapped onto a positive voltage at the integrator. The offset voltage is preferably as high as the maximum induced voltage that is anticipated, and similarly has a magnitude, for example, of 5 V. The offset voltage can be provided by means of an addition with an operational amplifier.

The two integrators that are arranged in parallel to one another are associated with a multiplexer unit, wherein the multiplexer unit is integrated into the circuit such that the first integrator measures and forwards the magnetic field strength, while the second integrator runs through firstly the short-circuit calibration and then the reference current calibration, wherein after completion of the calibration the second integrator measures and forwards the field strength, while the first integrator runs through the calibration cycle. In this manner, one integrator is always in operational mode, while the other integrator is in calibration mode. Thus, the measuring and further processing of the measured values can take place free of interrupts, while by virtue of the frequently executed calibration a high accuracy of measurement is achieved.

The inventive method for the measuring and closed-loop control of a magnetic field generated by an electromagnet comprises the following steps:
- measuring of the absolute field strength of a magnetic field at a point by means of a first measuring device
- measuring of the alteration of the magnetic field strength by means of a second measuring device
- integration of the alteration of the magnetic field strength measured by the second measuring device
- alignment of the absolute magnetic field strength and the integral magnetic field of the electromagnet
- comparison of the integral magnetic field thus obtained with a prescribed design value
- wherein at least two integrators are provided, of which one integrator integrates the alteration of the magnetic field strength measured by the second measuring device, and a second integrator runs through a calibration cycle.

As already explained, in the inventive device it is advantageous that by means of the at least two integrators a plurality of integrator paths ensue that are arranged in parallel to one another. That permits the integrator to be switched into the circuit operating under operational conditions and converts the voltage on the integrator provided by the second measuring device into countable pulses, from which in turn the current integral field strength can be determined, and that a second integrator is not active, but rather can pass through a calibration cycle.

The integrator is affected by various sources of error, which limit the accuracy of the integral. Time-varying errors result primarily from temperature fluctuations as a result of fluctuations of the ambient temperature or heating of the electronics after they have been switched on. A further source of errors is the noise, wherein noise from external sources can either affect the circuitry, or can arise as a result of processes in the interior.

The inventive method for purposes of calibration consists in the fact that with two successive calibration measurements the flux value of a pulse and an offset error are determined. In this manner all possible errors on a path from the pickup coil to the output are corrected. Here, the deviations of the quantities affected by the temperature fluctuations are measured, in that a prescribed high-accuracy voltage is fed in at input.

With a short-circuit at input to the integrator, the pulses generated by the voltage-to-frequency converter are counted over a time of, for example, 2 seconds. The average frequency of the measured pulses is deducted during the measurement phase from the pulses of the voltage-to-frequency converter in real time.

With a reference voltage at input to the integrator, which preferably amounts to half the maximum voltage to be anticipated, that is to say, for example, 2.5 V, the pulses generated are counted over a time of, for example, 2 seconds. From the reference voltage and the pulses counted the value of a pulse is calculated.

The recommended calibration time of 2 seconds forms a compromise between small discretisation errors with a longer calibration time, and smaller measurement errors as a result of a short calibration time in which the effects conditioned by the environment alter little.

In the following, some configurations of the inventive device and the inventive method are explained in more detail on the basis of the figures. These show, in each case schematically:
- Fig. 1: shows a ring accelerator;
- Fig. 2: shows an electromagnet in the form of a dipole;
- Fig. 3: shows an electromagnet in the form of a quadrupole;
- Fig. 4: shows a pickup coil for a quadrupole;
- Fig. 5: shows the current characteristic in dipoles of a ring accelerator;
- Fig. 6: shows a block circuit diagram of the device;
- Fig. 7: shows a circuit diagram of a voltage-to-frequency converter;
- Fig. 8: shows the closed-loop control for the magnetic field of a dipole magnet.

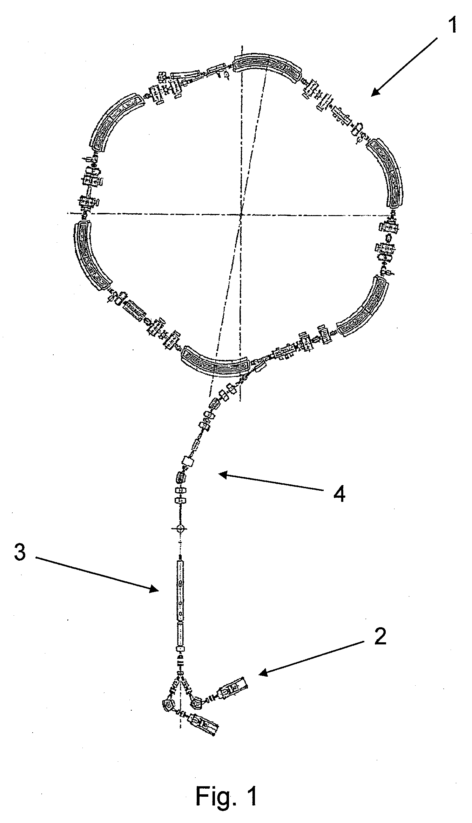

Figure 1 shows a ring accelerator 1 for purposes of generating accelerated ions for heavy ion therapy. An upstream source of ions 2 generates charged particles of the desired type of ion and accelerates them to the required velocity for injection into the linear accelerator 3. Hydrogen gas (H2) is used for the production of protons. For carbon ions carbon dioxide (CO2) is deployed. The beam extracted from the ions source contains a spectrum of all the elements present in the gas in various states of charge. In the following stripper the ions lose electrons that are still present. The stripped ions are then injected via a beam transfer line 4 into the ring accelerator 1, the synchrotron. After completion of the acceleration process executed in the ring accelerator 1 there follows the extraction of the ions.

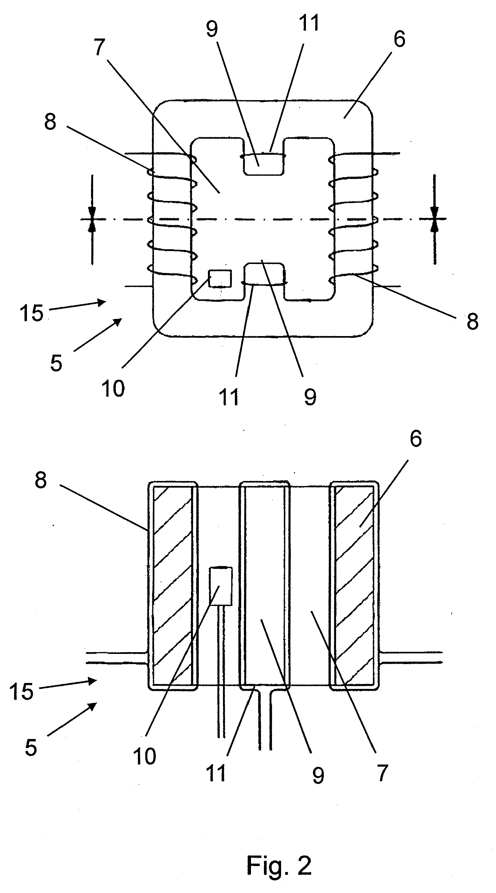

Figure 2 shows a dipole 5 for deflecting the ions rotating in the ring accelerator 1. The dipole 5 has a yoke 6 of a soft magnetic material with an approximately rectangular cross-section and is provided in the centre with a similar rectangular gap 7. For purposes of reducing eddy currents the yoke 6 can consist of a plurality of sheets laid one upon another. In a ring accelerator 1 the beam guide tube for the particle beam is arranged in the gap 7. Coils 8 are fitted on two sides of the dipole 5. When electrical current is applied to the coils 8, a magnetic field is induced in the dipole 5 and in the gap 7. A dipole 5 is therefore an electromagnet 15. For purposes of concentrating the magnetic flux lines running through the gap 7, the dipole is also fitted with poles 9, which are arranged on the sides connecting the two coils 8 and protrude into the gap 7. If the sides of the poles 9 facing towards each other are aligned so as to be parallel to one another, a homogeneous magnetic field is formed between the poles 9.

The dipoles 5 of a synchrotron direct the particle beam (ion beam) on a circular track through a homogeneous magnetic field located at right angles to the beam axis. The deflection angle describes the deflection that the particle beam experiences as a result of the dipole 5. The deflection angle is a function of the magnetic field strength B and the effective magnetic length L of the magnet, and also of the stiffness of the particle beam Bp.

For the measurement of the absolute field strength, a first measuring device 10 in the form of a Hall probe is arranged in the dipole 5. For purposes of measuring the integral field BL, a second measuring device 11 is provided in the form of a pickup coil (an induction coil), which is fitted along the beam guide of the dipole 5.

The pickup coil is fitted on the beam tube. The pickup coil surrounds the magnetic flux inclusive of the edge fields at the beginning and end of the dipole 5. In this configuration, the pickup coil is located in the vicinity of the beam, and the magnetic flux through the pickup coil is proportional to the integral magnetic field BL that the particle beam passes through. The actions of the magnetic field on the particle beam and on the induction coil are thus comparable.

The integral magnetic field, which prevails between the poles 9, can be calculated from two measured quantities: the Hall voltage measured by the first measuring device 10 and the integrated induced voltage measured by the second measuring device 11.

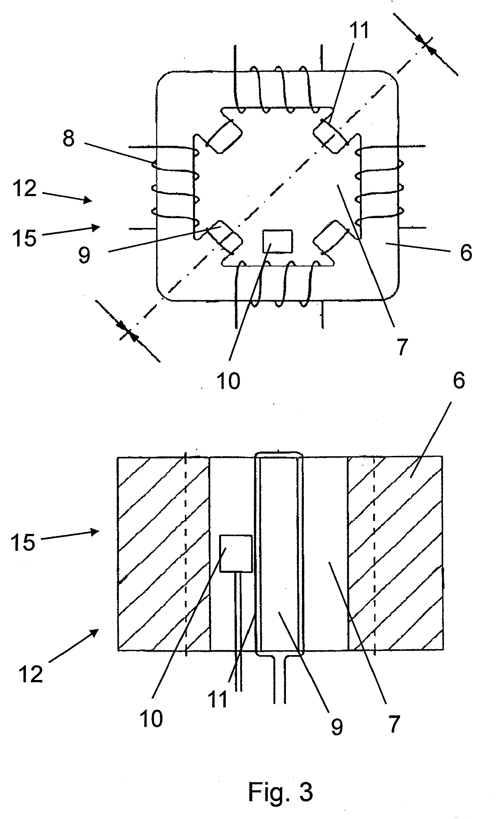

Figure 3 shows an electromagnet 15 designed as a quadrupole. The quadrupole 12 similarly has a yoke 6 of a soft magnetic material with an approximately rectangular cross-section and is provided in the centre with a rectangular gap 7. Coils 8 are fitted on all sides of the quadrupole 12. When electrical current is applied to the coils 8 a magnetic field is induced in the dipole 6 and in the gap 7. For purposes of concentrating the magnetic flux lines running through the gap 7 the quadrupole 12 is also fitted with poles 9, which are arranged on the corners of the yoke 6 and protrude into the gap 7.

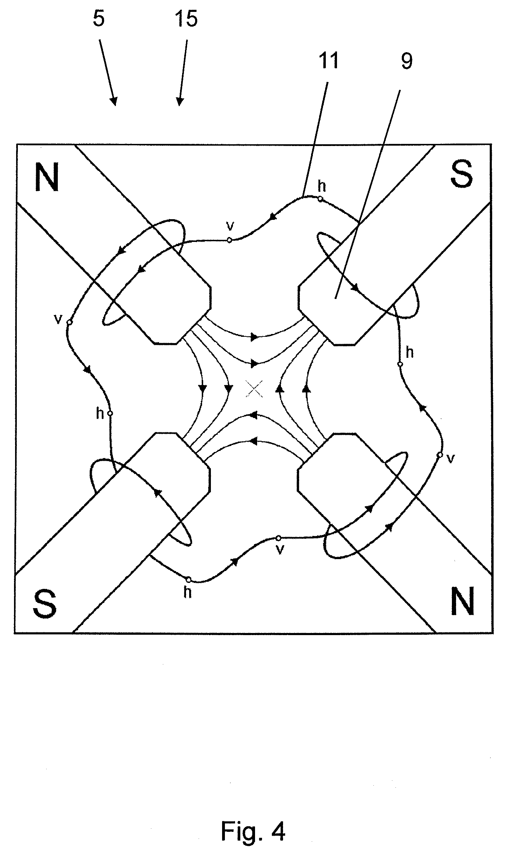

Figure 4 shows a quadrupole 12 with a pickup coil mounted on it. The pickup coils of the quadrupoles 12 are wrapped around the four poles 9. The direction of the windings alters on each pole 9, as represented in Figure 4. The coils around the two north poles must be opposed to the direction of the two south poles, in order that the voltages induced in the coil have the same polarity.

The signal from the pickup coils is preferably fed to the integrators using screened coaxial conductors.

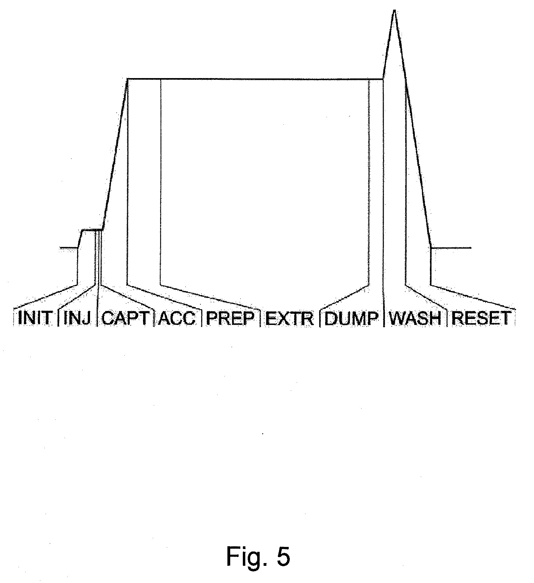

Figure 5 shows the current characteristic divided into phases in the dipoles 5 during an acceleration cycle:
INIT- preparation phase: In this phase all components of the synchrotron are prepared and set to the initial values for the subsequent injection process. In the first phase "INIT" the current in the magnet is increased from a quiescent current to the current for injection. In order that there are no steps in the set values for the current, a ramp is built up from two rounded parts and a linear part, which finally drives the magnet up to the integral field for injection.

INJ - injection phase: In this phase the beam is injected from the linear accelerator into the synchrotron and accumulated. For this purpose an accurate time-variant synchronisation with the linear accelerator cycle is required, as is an accurate synchronisation of the equipment activities. In the "INJ" phase the beam is injected with the multi-turn injection into the synchrotron. The current of the dipoles 5 must not alter during the time that the beam is accumulated over a number of rotations. From the start of the "INJ" phase, a beam is present in the synchrotron and the following phases must be executed by all items of equipment synchronously.

CAPT - RF-capture: The beam in the machine is bunched into packets. The magnetic field of the dipole 5 must not alter during the "CAPT" phase either. The beam is captured and formed into particle buckets.

ACC - acceleration phase: The bunched beam is accelerated. In this phase, accurate synchronisation of the frequency of the acceleration cavity with the dipole excitation is necessary in order to hold the beam on the design track and to prevent any growth of the momentum spread. Furthermore, exact synchronisation of the dipole excitation with the quadrupole excitation is required in order to avoid beam losses as a result of a variation of the Q-value. In the "ACC" phase acceleration of the beam up to the final energy level takes place. A linear gradient is prescribed for the stiffness of the beam Bp to which all other items of equipment are orientated. Here too, a rounding of the design value at the beginning of the ramp takes place as does a rounding at the end of the ramp, so as to avoid steps in the design values. The rotational frequency of the particles in the synchrotron is increased synchronously with the magnetic fields in the dipoles 5; by this means the particles are accelerated.

PREP - preparation phase for extraction: In this synchrotron phase preparation is made for the extraction of the beam. For this purpose, the extraction sextupoles are excited and the Q-value is driven near to the resonance frequency. The phase "PREP" prepares for the extraction of the beam. Essentially it consists of a waiting time of approximately 700 ms, in which the eddy currents of the synchrotron magnets decay at constant current. This phase is particularly interesting for the inventive closed-loop control for the magnetic field, since with the aid of the closed-loop control it can be dispensed with almost completely.

EXTR - extraction phase: In this phase the extraction of the beam is executed. For this purpose the RF-KO-exciter is excited and the beam is continuously decoupled from the machine via resonance processes. Only in this phase is an interruption of the extraction (spill pause) permissible. The extraction phase is completed by means of an external signal. In the extraction phase "EXTR" the beam is slowly extracted from the synchrotron with the aid of a RF-KO-exciter.

DUMP - beam destruction phase: In this phase any particle beam still remaining in the synchrotron is dumped. For this purpose the orbit is displaced upwards onto a vertically arranged scraper. After completion of the extraction, the residual beam is dumped on a scraper in the synchrotron. In both phases the current of the dipole 5 retains its value.

WASH - conditioning phase: In this phase, the quadrupoles and the dipoles are conditioned, in that the magnetic current is driven up to a reproducible maximum value. Thus, it is ensured that these magnets have identical magnetic characteristics at the start of each cycle. This phase can be switched out. In the conditioning phase "WASH", the magnets are firstly driven up to a maximum value and then back to their quiescent currents in order to ensure the reproducibility of the parameters independently of the remanence of the magnets. The hysteresis of the dipoles and quadrupoles in the synchrotron leads to the fact that a different remanence field is established if the magnets do not pass through the same hysteresis curve. This can only be ensured if they are driven up to the maximum field at the end of each cycle. With the inventive closed-loop control for the magnetic field this phase can also be dispensed with.

RESET - reset phase: In this phase the initial conditions are re-established for all components.

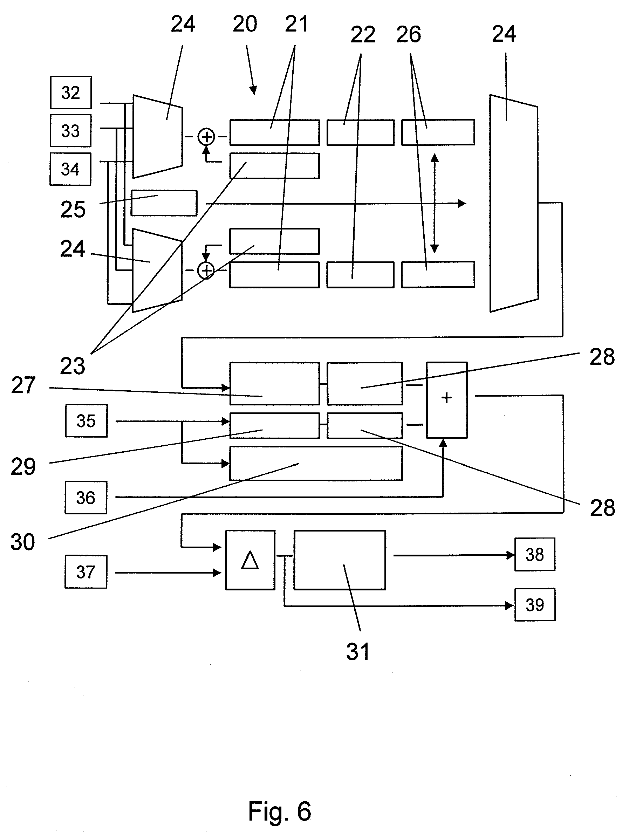

Figure 6 shows a block circuit diagram of the inventive device. The integrator 20 delivers in real time the integral of the analog voltage at input, which arises in the pickup coil (second measuring device 11) as a result of the influence of alterations of the magnetic field in the dipole 5. A calibration of the integrator 20 takes place continuously and is executed under operational conditions. For this purpose two identical integration paths are used, provided by the voltage-to-frequency converter 21 and the frequency counter 22, which automatically switch over after the calibration. Thus the inventive device has two integrators 20 arranged in parallel to one another. The ongoing measurements are not impaired thereby. A new calibration is executed every 4 seconds. The calculations that are necessary for this purpose take place in a processor unit. The result of the integration has a resolution of 20 bits and an accuracy of 10-5 Vs.

The magnetic flux that flows through the pickup coil is calculated from the time-variant integral of the voltage (pickup voltage) generated by the coil, which varies between +5 V and -5 V. For this purpose the pickup voltage is firstly connected in an impedance converter, implemented as an operational amplifier with a magnification factor of 1, to a low resistance voltage source. Moreover the pickup voltage is displaced by an offset voltage 23, here by 5 V. The input voltage thus generated therefore varies in the range from 0 to 10 V. The input voltage serves as an input signal for the following integrator 20, which contains a voltage-to-frequency converter (VF-converter) 21.

The integral magnetic field is calculated from two measured quantities, the Hall voltage and the integrated induced voltage of the pickup coil. An offset compensation for the Hall probe 10 and a drift correction for the pickup coil 11 are also required. The integrator 20 is configured such that it delivers in real time the integral of the analog voltage at the input, which is measured by the pickup coil 11. Furthermore a calibration of the integrator 20 takes place continuously, wherein this can be executed under operational conditions. For this purpose two identical integration paths are provided.

The inventive circuitry features two paths for simultaneous measurement and calibration. As a result of the integration the integrated voltage is to be represented in the form of pulses that are generated at a certain frequency. Here the actual output signal of the integrator 20, the time-variant sequence of pulses, is used directly. The frequency is the number of pulses per unit of time. The number of pulses delivered in a time interval by a voltage-to-frequency converter 21 reproduces the integrated input voltage.

List of the reference symbols used in Figure 6:
20 Integrator
21 Voltage-to-frequency converter
22 Counter
23 Offset voltage (5V)
24 Multiplexer (MUX)
25 Logic for the multiplexer
26 Calibration
27 Integrator (counter)
28 Calibration
29 Analog-to-digital converter (ADC)
30 Current source, temperature compensation
31 PI-controller (proportional-integral controller)
32 Voltage from the pickup coil (pickup voltage), value measured by second measuring device 11
33 Reference voltage (2,5 V)
34 Earthing (GND)
35 Value measured by Hall probe, value measured by first measuring device 10
36 Synchronisation (Sync)
37 Design value for integral field
38 Actuating variable
39 Field error

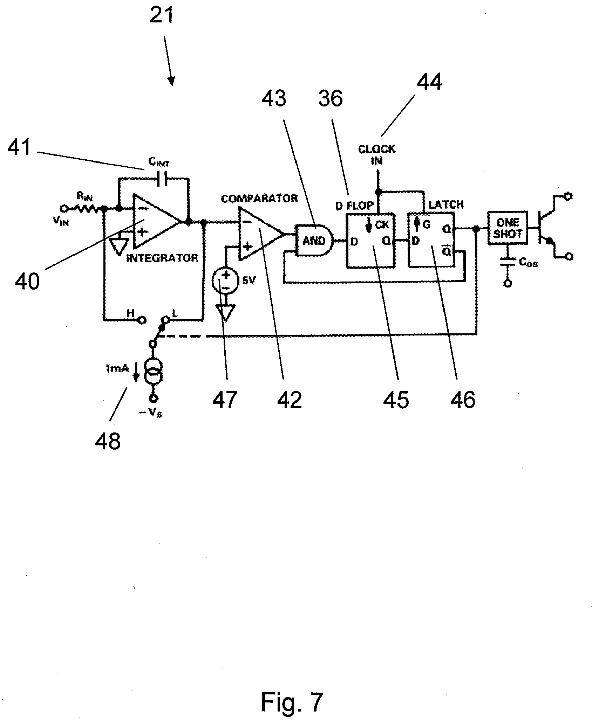

Figure 7 shows in detail the circuit diagram for a synchronous voltage-to-frequency converter 21. An RC-integrator 40 discharges the capacitor 41 via the input resistance, so that the state of charge in the capacitor 41 alters over a time interval. The voltage on the capacitor 41 is given by its charge Q(t) divided by its capacitance CINT and on the comparator 42 is compared with a constant voltage 47 of +5 V. If the capacitor voltage falls below this threshold value, the logic connected to the comparator 42 is brought into play. This charges up the capacitor 41 by a prescribed amount and generates a pulse at the output. As a result of the applied voltage the charge in the capacitor 41 lowers and its voltage eventually falls below the reference voltage. As a result the output of the comparator 42 and the AND-gate 43 moves from Low to High. In the next falling flank of the clock 44 the altered situation is processed and the DFLOP output 45 moves to High. In the next rising flank of the clock 44 AND-out returns to Low and latch-out 46 returns to High, as a result of which a pulse is now displaced. At the same time the reset phase of the capacitor 41 begins, in which a charge is supplied to the capacitor for a clock interval with a constant current of 1 mA. Since the reference voltage is reduced by the current through RIN, a partial discharge also takes place during this clock interval. In the following rising flank of the clock 44 the charging process is completed and the capacitor 41 discharges once again under the constant influence of the input voltage.

In the following cycle there is again a failure to reach the comparator threshold value and the above-described sequence is repeated. Since in the discharge phase the amount discharged is not exactly the same as occurs in the recharging process during a time interval, the average value of the sawtooth-shaped voltage of the capacitor 41 drifts away from the threshold value. After this there follows an extended or an abbreviated discharge time, which once again creates an adjustment. If the discharge current is too large the capacitor 41 is not sufficiently charged up during a clock time period and the sawtooth-shaped capacitor voltage drifts continuously downwards. It no longer achieves the threshold value for the voltage. In this case an output pulse occurs in each second time cycle.

The inventive method for calibration purposes consists in the fact that with two successive calibration measurements the flux value of a pulse and an offset error are determined. In this manner all possible errors on the path from the pickup coil 11 to the output are corrected. Here the deviations of the quantities affected by the temperature fluctuations are measured, in that at input a prescribed high-accuracy voltage is fed in.

With a short-circuit at the input to the integrator 20 the pulses generated by the voltage-to-frequency converter are counted over a time of 2 seconds. The average frequency of the measured pulses is deducted during the measurement phase from the pulses of the voltage-to-frequency converter 21 in real time.

With a reference voltage at the input to the integrator 20, which preferably amounts to half the maximum voltage to be anticipated, that is to say 2.5 V, the pulses generated are counted over a time of 2 seconds. From the reference voltage and the pulses counted the value of a pulse is calculated.

The recommended calibration time of 2 seconds forms a compromise between small discretisation errors with a longer calibration time and smaller measurement errors as a result of a short calibration time in which the effects conditioned by the environment alter little.

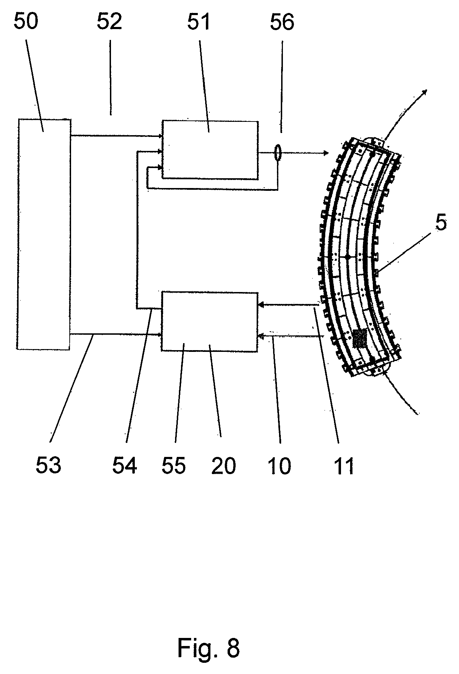

Figure 8 shows a block circuit diagram of a closed-loop controller for the magnetic field of a dipole 5. The accelerator control system 50 supplies the magnet power supply unit 51 with a design value 52 for the current 56 and the closed-loop controller for the magnetic field 55 with a second design value 53 for the integral field. Via a feedback loop a correction signal 54 is forwarded to the magnet power supply unit 51. The electromagnet 5, 15 generates from the current 56 of the magnet power supply unit 51 a magnetic field, which is measured with the closed-loop controller for the magnetic field 55. The closed-loop controller for the magnetic field 55 forwards the field error, the deviation from the second design value 53, as a correction signal 54 to the magnet power supply unit 51, which stabilises the field error by a correction of the current 56. The closed-loop controller for the magnetic field 55 contains the inventive device with the integrator 20, that is to say, the integrator parts arranged in parallel to one another.

## Claims

1. Device for the measuring and closed-loop control of a magnetic field generated by means of an electromagnet (5, 12, 15) comprising a first measuring device (10) for purposes of measuring the absolute magnetic field strength of the magnetic field, a second measuring device (11) for purposes of measuring the alteration of the magnetic field strength of the magnetic field, at least two integrators (20) for purposes of determining the magnetic field strength of the alteration of the magnetic field strength measured in the second measuring device (11), whose integrators are arranged in parallel to one another, calibration means, a unit for purposes of comparing the magnetic field strength measured by the first measuring device (10) and the second measuring device (11), and a further unit for purposes of comparing the measured magnetic field strength with a prescribed design field strength, **characterised in that**, the integrators (20) are arranged such that one integrator (20) integrates the values measured by the second measuring device (11), while the other integrator (20) runs through a calibration cycle.

2. The device in accordance with Claim 1, **characterised in that**, the first measuring device (10) is designed as a Hall probe.

3. The device in accordance with Claim 1 or 2, **characterised in that**, the second measuring device (11) is designed as a pickup coil.

4. The device in accordance with Claim 3, **characterised in that**, the pickup coil is fitted along the beam guide of the electromagnet (5, 12, 15), and integrally measures the magnetic field occurring in the magnet gap.

5. The device in accordance with one of the Claims 1 to 4, **characterised in that**, the integrators (20) feature a voltage-to-frequency converter (21).

6. The device in accordance with one of the Claims 1 to 5, **characterised in that**, the integrators (20) feature a comparator (42), a sample-and-hold element, a negative-feedback capacitor (41) and a flip-flop cycled via a clock (44), which discharges the negative-feedback capacitor (41) after a described time has elapsed.

7. The device in accordance with one of the Claims 1 to 6, **characterised in that**, the integrators (20) are assigned to a time-controlled switching unit (24), which initiates the changeover of the operating states of the integrators (20).

8. The device in accordance with one of the Claims 1 to 7, **characterised in that**, the second measuring device (11) measures a voltage induced as a consequence of an alteration of the magnetic field, which voltage forms the input value to the integrator (20).

9. The device in accordance with Claim 8, **characterised in that**, the induced voltage (32) measured by the second measuring device (11) is provided with an offset voltage (23), so that the measured induced voltage (32) plus the offset voltage (23) forms the input signal to the integrator (20).

10. The device in accordance with one of the Claims 1 to 9, **characterised in that**, the integrators (20) that are arranged in parallel to one another are assigned to a multiplexer unit (24), wherein the multiplexer unit (24) is integrated into the circuit such that the first integrator (20) measures and forwards the magnetic field strength, while the second integrator (20) runs through firstly the short-circuit calibration and then the reference current calibration, wherein after completion of the calibration the second integrator (20) measures and forwards the field strength, while the first integrator (20) runs through the calibration cycle.

11. A method for the measuring and closed-loop control of a magnetic field generated by an electromagnet (5, 12, 15), comprising the following steps:
- measuring of the absolute field strength of a magnetic field at a point by means of a first measuring device (10)
- measuring of the alteration of the magnetic field strength by means of a second measuring device (11)
- integration of the alteration of the magnetic field strength measured by the second measuring device (11)
- alignment of the absolute magnetic field strength and the integrated field strength
- comparison of the field strength thus obtained with a prescribed design field strength
- wherein at least two integrators (20) are provided, of which one integrator (20) integrates the alteration of the magnetic field strength measured by the second measuring device (11), and a second integrator runs through a calibration cycle.

12. The method in accordance with Claim 11, **characterised in that**, both the first measuring device (10) and also the second measuring device (11) are calibrated before the start of the measurements.

13. The method in accordance with Claim 12, **characterised in that**, in a first step the input to the integrator (20) is short-circuited for purposes of calibrating the integrator (20).

14. The method in accordance with Claim 13, **characterised in that**, in a second step the input of the integrator (20) is connected to a reference voltage source (33).

15. The method in accordance with one of the Claims 11 to 14, **characterised in that**, correction pulses are determined with the short-circuit calibration, which pulses are subtracted from the measured value in real time during the measurements.

## Patentansprüche

1. Vorrichtung für die Messung und Regelkreissteuerung eines mittels eines Elektromagneten (5, 12, 15) erzeugten Magnetfeldes, die Folgendes umfasst: eine erste Messvorrichtung (10) zum Messen der absoluten Magnetfeldstärke des Magnetfeldes, eine zweite Messvorrichtung (11) zum Messen der Änderung der Magnetfeldstärke des Magnetfeldes, mindestens zwei Integratoren (20) zum Bestimmen der Magnetfeldstärke der Änderung der in der zweiten Messvorrichtung (11) gemessenen Magnetfeldstärke, wobei die Integratoren parallel zueinander angeordnet sind, ein Kalibrierungsmittel, eine Einheit zum Vergleichen der Magnetfeldstärke, die durch die erste Messvorrichtung (10) und die zweite Messvorrichtung (11) gemessen wurde, und eine weitere Einheit zum Vergleichen der gemessenen Magnetfeldstärke mit einer vorgeschriebenen Sollfeldstärke, **dadurch gekennzeichnet, dass** die Integratoren (20) so angeordnet sind, dass ein Integrator (20) die durch die zweite Messvorrichtung (11) gemessenen Werte integriert, während der andere Integrator (20) einen Kalibrierungszyklus durchläuft.

2. Vorrichtung nach Anspruch 1, **dadurch gekennzeichnet, dass** die erste Messvorrichtung (10) als eine Hall-Sonde ausgeführt ist.

3. Vorrichtung nach Anspruch 1 oder 2, **dadurch gekennzeichnet, dass** die zweite Messvorrichtung (11) als eine Sondenspule ausgeführt ist.

4. Vorrichtung nach Anspruch 3, **dadurch gekennzeichnet, dass** die Sondenspule entlang der Auslegerführung des Elektromagneten (5, 12, 15) angeordnet ist und das in dem Magnetspalt auftretende Magnetfeld integral misst.

5. Vorrichtung nach einem der Ansprüche 1 bis 4, **dadurch gekennzeichnet, dass** die Integratoren (20) einen Spannung-Frequenz-Wandler (21) aufweisen.

6. Vorrichtung nach einem der Ansprüche 1 bis 5, **dadurch gekennzeichnet, dass** die Integratoren (20) Folgendes aufweisen: einen Komparator (42), ein Abtast- und-Speicher-Element, einen Negativrückkopplungskondensator (41) und einen über einen Taktgeber (44) zyklisch geschalteten Flipflop, der den Negativrückkopplungskondensator (41) nach Verstreichen einer angegebenen Zeit entlädt.

7. Vorrichtung nach einem der Ansprüche 1 bis 6, **dadurch gekennzeichnet, dass** die Integratoren (20) einer zeitgesteuerten Schalteinheit (24) zugewiesen werden, die den Wechsel der Betriebszustände der Integratoren (20) initiiert.

8. Vorrichtung nach einem der Ansprüche 1 bis 7, **dadurch gekennzeichnet, dass** die zweite Messvorrichtung (11) eine Spannung misst, die als eine Folge einer Änderung des Magnetfeldes induziert wird, wobei diese Spannung den Eingangswert in den Integrator (20) bildet.

9. Vorrichtung nach Anspruch 8, **dadurch gekennzeichnet, dass** die durch die zweite Messvorrichtung (11) gemessene induzierte Spannung (32) mit einer Versatzspannung (23) bereitgestellt wird, so dass die gemessene induzierte Spannung (32) zuzüglich der Versatzspannung (23) das Eingangssignal in den Integrator (20) bildet.

10. Vorrichtung nach einem der Ansprüche 1 bis 9, **dadurch gekennzeichnet, dass** die Integratoren (20), die parallel zueinander angeordnet sind, einer Multiplexereinheit (24) zugewiesen werden, wobei die Multiplexereinheit (24) so in den Schaltkreis integriert ist, dass der erste Integrator (20) die Magnetfeldstärke misst und weiterleitet, während der zweite Integrator (20) zuerst die Kurzschlusskalibrierung und dann die Referenzstromkalibrierung durchläuft, wobei der zweite Integrator (20) nach der Vollendung der Kalibrierung die Feldstärke misst und weiterleitet, während der erste Integrator (20) den Kalibrierungszyklus durchläuft.

11. Verfahren für die Messung und Regelkreissteuerung eines durch einen Elektromagneten (5, 12, 15) erzeugten Magnetfeldes, das die folgenden Schritte umfasst:
- Messen der absoluten Feldstärke eines Magnetfeldes an einem Punkt mittels einer ersten Messvorrichtung (10);
- Messen der Änderung der Magnetfeldstärke mittels einer zweiten Messvorrichtung (11);
- Integration der Änderung der durch die zweite Messvorrichtung (11) gemessenen Magnetfeldstärke;
- Ausrichtung der absoluten Magnetfeldstärke und der integrierten Feldstärke;
- Vergleich der so erhaltenen Feldstärke mit einer vorgeschriebenen Sollfeldstärke;
- wobei mindestens zwei Integratoren (20) bereitgestellt sind, von denen ein Integrator (20) die Änderung der durch die zweite Messvorrichtung (11) gemessenen Magnetfeldstärke integriert und ein zweiter Integrator einen Kalibrierungszyklus durchläuft.

12. Verfahren nach Anspruch 11, **dadurch gekennzeichnet, dass** sowohl die erste Messvorrichtung (10) als auch die zweite Messvorrichtung (11) vor Beginn der Messungen kalibriert werden.

13. Verfahren nach Anspruch 12, **dadurch gekennzeichnet, dass** in einem ersten Schritt der Eingang in den Integrator (20) zum Zweck der Kalibrierung des Integrators (20) kurzgeschlossen wird.

14. Verfahren nach Anspruch 13, **dadurch gekennzeichnet, dass** in einem zweiten Schritt der Eingang des Integrators (20) mit einer Referenzspannungsquelle (33) verbunden wird.

15. Verfahren nach einem der Ansprüche 11 bis 14, **dadurch gekennzeichnet, dass** mit der Kurzschlusskalibrierung Korrekturimpulse bestimmt werden, wobei diese Impulse von dem gemessenen Wert in Echtzeit während der Messungen subtrahiert werden.

## Revendications

1. Dispositif de mesure et de commande en boucle fermée d'un champ magnétique généré au moyen d'un électroaimant (5, 12, 15) comprenant un premier moyen de mesure (10) destiné à mesurer l'intensité de champ magnétique absolue du champ magnétique, un second moyen de mesure (11) destiné à mesurer la modification d'intensité du champ magnétique, au moins deux intégrateurs (20) destinés à déterminer l'intensité du champ magnétique de la modification d'intensité du champ magnétique mesurée dans le second moyen de mesure (11), lesdits intégrateurs étant agencés parallèlement les uns aux autres, un moyen d'étalonnage, une unité destinée à comparer l'intensité du champ magnétique mesurée par le premier moyen de mesure (10) et le second moyen de mesure (11), et une autre unité destinée à comparer l'intensité du champ magnétique mesurée avec une intensité de champ de conception prescrite, **caractérisé en ce que** les intégrateurs (20) sont agencés de telle sorte qu'un intégrateur (20) intègre les valeurs mesurées par le second moyen de mesure (11), tandis que l'autre intégrateur (20) passe à travers un cycle d'étalonnage.

2. Dispositif selon la revendication 1, **caractérisé en ce que** le premier moyen de mesure (10) est conçu sous la forme d'une sonde de Hall.

3. Dispositif selon la revendication 1 ou 2, **caractérisé en ce que** le second moyen de mesure (11) est conçu sous la forme d'une bobine de sondage.

4. Dispositif selon la revendication 3, **caractérisé en ce que** la bobine de sondage est agencée le long du guide de faisceau de l'électroaimant (5, 12, 15) et mesure intégralement le champ magnétique se produisant dans l'espace magnétique.

5. Dispositif selon une des revendications 1 à 4, **caractérisé en ce que** les intégrateurs (20) présentent un convertisseur tension-fréquence (21).

6. Dispositif selon une des revendications 1 à 5, **caractérisé en ce que** les intégrateurs (20) présentent un comparateur (42), un élément d'essai et de maintien, une capacitance à rétroaction négative (41) et un flip-flop commandé de manière cyclique par le biais d'une horloge (44), laquelle décharge la capacitance à rétroaction négative (41) après qu'un délai décrit se soit écoulé.

7. Dispositif selon une des revendications 1 à 6, **caractérisé en ce que** les intégrateurs (20) sont affectés à une unité de commutation commandée en fonction du temps (24), laquelle initie le changement d'états de fonctionnement des intégrateurs (20).

8. Dispositif selon une des revendications 1 à 7, **caractérisé en ce que** le second moyen de mesure (11) mesure une tension induite en conséquence d'une modification du champ magnétique, laquelle tension forme la valeur d'entrée dans l'intégrateur (20).

9. Dispositif selon la revendication 8, **caractérisé en ce que** la tension induite (32) mesurée par le second moyen de mesure (11) est fournie avec une tension de décalage (23), de sorte que la tension induite mesurée (32) plus la tension de décalage (23) forment le signal d'entrée dans l'intégrateur (20).

10. Dispositif selon une des revendications 1 à 9, **caractérisé en ce que** les intégrateurs (20) qui sont agencés parallèlement les uns aux autres sont affectés à une unité de multiplexage (24), l'unité de multiplexage (24) étant intégrée dans le circuit de telle sorte que le premier intégrateur (20) mesure et achemine l'intensité du champ magnétique, tandis que le second intégrateur (20) passe premièrement à travers l'étalonnage de court-circuit, puis l'étalonnage de courant de référence, dans lequel, après réalisation de l'étalonnage, le second intégrateur (20) mesure et achemine l'intensité du champ, tandis que le premier intégrateur (20) passe à travers le cycle d'étalonnage.

11. Procédé de mesure et de commande en boucle fermée d'un champ magnétique généré par un électroaimant (5, 12, 15), comprenant les étapes suivantes :
- mesure de l'intensité absolue d'un champ magnétique en un point au moyen d'un premier moyen de mesure (10) ;
- mesure de la modification d'intensité du champ magnétique au moyen d'un second moyen de mesure (11) ;
- intégration de la modification d'intensité du champ magnétique mesurée par le second moyen de mesure (11) ;
- alignement de l'intensité de champ magnétique absolue et de l'intensité de champ intégrée ;
- comparaison de l'intensité de champ ainsi obtenue avec une intensité de champ de conception prescrite ;
- dans lequel au moins deux intégrateurs (20) sont prévus, dont un intégrateur (20) intègre la modification d'intensité du champ magnétique mesurée par le second moyen de mesure (11), et un second intégrateur passe à travers un cycle d'étalonnage.

12. Procédé selon la revendication 11, **caractérisé en ce qu'**à la fois le premier moyen de mesure (10) et le second moyen de mesure (11) sont étalonnés avant le démarrage des mesures.

13. Procédé selon la revendication 12, **caractérisé en ce que**, dans une première étape, l'entrée dans l'intégrateur (20) est court-circuitée dans le but d'étalonner l'intégrateur (20).

14. Procédé selon la revendication 13, **caractérisé en ce que**, dans une seconde étape, l'entrée dans l'intégrateur (20) est reliée à une source de tension de référence (33).

15. Procédé selon une des revendications 11 à 14, **caractérisé en ce que** des impulsions de correction sont déterminées avec l'étalonnage de court-circuit, lesdites impulsions étant soustraites de la valeur mesurée en temps réel pendant les mesures.
